# EUROPÄISCHE PATENTSCHRIFT

(11) **EP 2 893 577 B1**
(45) Veröffentlichungstag und Bekanntmachung des Hinweises auf die Patenterteilung: **08.01.2020**
(21) Anmeldenummer: 13759184.8
(22) Anmeldetag: 06.09.2013
(51) Int. Cl.: H01L 51/52, H01L 51/56

(54) **ELEKTROOPTISCHES BAUELEMENT MIT QUANTENDOT-STRUKTUR**
ELECTRO-OPTICAL COMPONENT HAVING A QUANTUM DOT STRUCTURE
COMPOSANT ÉLECTRO-OPTIQUE À STRUCTURE DE POINTS QUANTIQUES

(30) Priorität: 06.09.2012 DE 102012215792
(43) Veröffentlichungstag der Anmeldung: 15.07.2015
(73) Patentinhaber: Zumtobel Lighting GmbH, 6850 Dornbirn (AT)
(72) Erfinder: SIEGEL, Martin, 88131 Bodolz (DE); ECKBAUER, Verena, 82327 Tutzing (DE)
(74) Vertreter: Thun, Clemens
(86) Internationale Anmeldenummer: PCT/EP2013/068436
(87) Internationale Veröffentlichungsnummer: WO 2014/037484

(56) Entgegenhaltungen:
- WO-A1-2012/013270
- US-A1- 2012 168 815
- US-B1- 8 003 008
- BAOHUA JIA ET AL: "Highly Non-Linear Quantum Dot Doped Nanocomposites for Functional Three-Dimensional Structures Generated by Two-Photon Polymerization", ADVANCED MATERIALS, Bd. 22, Nr. 22, 11. Juni 2010 (2010-06-11) , Seiten 2463-2467, XP055083867, ISSN: 0935-9648, DOI: 10.1002/adma.201000513
- XIA HONG ET AL: "Three-dimensional micronanofabrication via two-photon-excited photoisomerization", APPLIED PHYSICS LETTERS, AIP, AMERICAN INSTITUTE OF PHYSICS, MELVILLE, NY, US, Bd. 95, Nr. 8, 27. August 2009 (2009-08-27), Seiten 83118-83118, XP012122839, ISSN: 0003-6951, DOI: 10.1063/1.3213351

## Beschreibung

Die vorliegende Erfindung betrifft ein elektrooptisches Bauelement, das eine Polymerschicht aufweist, in die eine Quantendot-Struktur eingebettet ist. Insbesondere ist die Quantendot-Struktur durch Zwei-Photonenpolymerisation hergestellt. Genauer gesagt ist die Quantendot-Struktur ein mittels Zwei-Photonenpolymerisation strukturierter Abschnitt der Polymerschicht.

Die vorliegende Erfindung basiert auf der Nutzung sogenannter Quantendot-Strukturen, um die Effizienz elektrooptischer Bauelemente zu steigern beziehungsweise anzupassen. Die Abmessungen eines einzelnen Quantendots liegen in allen drei Raumdimensionen typischerweise im Nanometerbereich. Ein Quantendot weist aufgrund dieser sehr geringen Abmessungen Materialeigenschaften auf, die abhängig von seiner Größe sind. Insbesondere können in einem Quantendot Quanteneffekte für Ladungen aufgrund deren räumlich sehr starken Lokalisierung auftreten. Beispielweise bilden sich im Quantendot diskrete Energieniveaus für Ladungen aus, die dazu genutzt werden können, bestimmte Eigenschaften elektrooptischer Bauelemente gezielt zu beeinflussen.

Aus dem Stand der Technik sind bereits Quantendots bekannt, die allerdings nur sehr schwer in kontrollierten 3D-Strukturen angeordnet werden können und insbesondere sehr schwer auf kontrollierte Art und Weise in großer Anzahl ausgebildet und dimensioniert und gleichzeitig kontrolliert angeordnet werden können.

Insbesondere sind sogenannte kolloidale Quantendots bekannt, die in einer Flüssigphase hergestellt werden. Die kolloidalen Quantendots erlauben ein sehr präzises Größenwachstum und damit ein sehr genaues Einstellen einer Bandlücke, d.h. auch einer Emissionswellenlänge. Kolloidale Quantendots lassen sich allerdings praktisch gar nicht räumlich anordnen. Bestenfalls ist eine oder mehrere halbwegs geordnete dichtgelagerte Schicht von Quantendots erreichbar.

Des Weiteren sind sogenannte epitaktische Quantendots bekannt, die durch Molekularstrahlepitaxie auf einer Oberfläche aufgewachsen werden. Die epitaktischen Quantendots können gezielt gewachsen werden, d.h. es ist möglich einige spezielle 3D-Strukturen durch beispielweise Mikrostrukturierung der Oberfläche herzustellen. Allerdings ist der Einfluss auf die Größe der Quantendots und somit eine Emissionswellenlänge sehr gering.

Durch die Verwendung der sogenannten Zwei-Photonenpolymerisation ist es nun erstmals möglich, Strukturen kleinster Abmessungen direkt und vor allem auf kontrollierbare und genau steuerbare Art und Weise zu erzeugen. Durch entsprechende Zwei-Photonenlithographie, die den Effekt der Zwei-Photonenpolymerisation ausnutzt, können dreidimensionale Strukturen mit Abmessungen ausgebildet werden, die denjenigen von Quantendots entsprechen.

In der US 8,003,008 B1 sind OLEDs als elektrooptische Bauelemente mit einer kolloidalen Polymerschicht gezeigt. In dem Dokument Baohua Jia et al: "Highly Non-Linear Quantum Dot Doped Nanocomposites for Functional Three-Dimensional Structures Generated by Two-Photon Polymerization" Advanced Materials, Bd. 22, Nr. 22, Seiten 2463 - 2467, XP055083867, ISSN 0935-9648, ist die Zwei-Photonenpolymerisation gezeigt.

Die vorliegende Erfindung stellt sich zur Aufgabe, die Effizienz bekannter elektrooptischer Bauelemente zu steigern beziehungsweise anzupassen. Dazu schlägt die vorliegende Erfindung vor, eine Quantendot-Struktur bestehend aus einer Vielzahl von Quantendots in ein Bauelement zu integrieren. Insbesondere kann die oben genannte Aufgabe durch ein elektrooptisches Bauelement gemäß den beigefügten Ansprüchen gelöst werden. Der unabhängige Anspruch beschreibt den Kerngedanken der Erfindung. Die abhängigen Ansprüche bilden diesen Kerngedanken vorteilhaft weiter.

Die vorliegende Erfindung betrifft ein elektrooptisches Bauelement das eine Polymerschicht umfasst, in die eine Quantendot-Struktur eingebettet ist, wobei die Quantendot-Struktur ein durch Zwei-Photonenpolymerisation strukturierter Abschnitt der Polymerschicht ist. Das elektrooptische Bauelement ist dabei eine organische Leuchtdiode, die wenigstens eine organische Schicht zur Abgabe von Licht umfasst, wobei die Polymerschicht mit der eingebetteten Quantendot-Struktur an die wenigstens eine organische Schicht angrenzt. Die Quantendot-Struktur ist dazu ausgelegt, den Wellenlängenbereich, vorzugsweise einen blauen Wellenlängenbereich, von wenigstens einem Teil des Lichts, das von der wenigstens einen organischen Schicht abgegeben wird, zu verändern. Alternativ ist die Quantendot-Struktur dazu ausgelegt, eine Elektronen-Leitfähigkeit in einer Elektronen-Transportschicht und/oder eine Löcher-Leitfähigkeit in einer Löcher-Transportschicht des Bauelements zu verändern. Alternativ ist die Quantendot-Struktur zur direkten Lichtabgabe ausgelegt.

Die Quantendot-Struktur kann derart ausgelegt sein, dass sie selbst als Ganzes einen Quanteneffekt erzeugt. Beispielweise kann durch die Größe der Quantendots und den Abstand zwischen den einzelnen Quantendots eine Bandlücke in der Quantendot-Struktur erzeugt werden. Das bedeutet es gibt kollektive diskrete Energieniveaus für Ladungen in der Quantendot-Struktur. Die Quantendot-Struktur kann auch selbst als Quantendot wirken. Die Quantendot-Struktur kann die Eigenschaften der Polymerschicht (die Polymerschicht kann auch ein Polymerblock sein) gezielt beeinflussen. Bei einer Polymerschicht mit lichtemittierenden Eigenschaften, kann die Quantendot-Struktur die Lichtemission beeinflussen (beispielweise durch ihre Bandlücke) und beispielweise die Wellenlänge des emittierten Lichts verändern. Die Quantendot-Struktur kann auch eine fraktale Antenne bilden. Mit Hilfe einer derartigen Struktur kann Licht gezielt empfangen und ausgesendet werden. Die Quantendot-Struktur kann auch eine optische Antenne bilden.

Die organische Leuchtdiode kann Licht aus einem beliebigen Wellenlängenbereich, d.h. beliebiger Farbe abgeben.

Dadurch, dass die Polymerschicht mit der eingebetteten Quantendot-Struktur an die wenigstens eine organische Schicht angrenzt, wird eine bestmögliche Kopplung und der größte Effekt erzielt.

Wie zuvor erläutert, ist bei einer Ausgestaltung vorgesehen, dass die Quantendot-Struktur dazu ausgelegt, den Wellenlängenbereich, vorzugsweise einen blauen Wellenlängenbereich, von wenigstens einem Teil des Lichts, das von der wenigstens einen organischen Schicht abgegeben wird, zu verändern.

Das Bauelement ist vorzugsweise mit einer organischen Schicht zur Abgabe von Licht aus dem blauen Wellenlängenbereich versehen. Die Quantendot-Struktur wirkt dann ähnlich wie ein Leuchtstoff (Phosphor) der für Leuchtdioden bekannt ist. Damit kann gemischtes Licht, beispielweise weißes Licht erzeugt werden. Die Quantendot-Struktur kann beispielweise zusätzlich zu dem blauen Licht der organischen Schicht gelbes Licht abgeben. Der Gesamteindruck ergibt dann weißes Licht.

Wie zuvor erläutert, ist bei einer weiteren Ausgestaltung vorgesehen, dass die Quantendot-Struktur dazu ausgelegt ist, eine Elektronen-Leitfähigkeit in einer Elektronen-Transportschicht und/oder eine Löcher-Leitfähigkeit in einer Löcher-Transportschicht des Bauelements zu verändern.

Eine hohe Effizienz von organischen Leuchtdioden (OLED) ist nur erreichbar, wenn die entsprechenden Transportschichten geeignete Eigenschaften, insbesondere eine hohe Leitfähigkeit, aufweisen. Durch das Einbringen der Quantendot-Struktur kann diese Leitfähigkeit verbessert werden, um wiederum die Effizienz der OLED zu verbessern.

Vorteilhafterweise ist die Quantendot-Struktur zwischen wenigstens zwei organischen Schichten angeordnet, wobei die Quantendot-Struktur dazu ausgelegt ist, eine Bandlücke zwischen den Schichten des Bauelements zu verändern.

Auf diese Art kann gezielt die Leitfähigkeit zwischen den verschiedenen Schichten beeinflusst werden, da diese abhängig vom Bandverlauf im Bauelement ist.

Wie zuvor erläutert, ist bei einer weiteren Ausgestaltung vorgesehen, dass die Quantendot-Struktur zur direkten Lichtabgabe ausgelegt ist.

Die gesamte Lichtabgabe der OLED kann so verstärkt werden. Die Effizienz kann verbessert werden.

Die vorliegende Erfindung betrifft ferner ein Verfahren zum Herstellen eines elektrooptischen Bauelements, welches das Herstellen einer Quantendot-Struktur aus Quantendots in einer Polymerschicht umfasst, indem wenigstens ein Abschnitt der Polymerschicht durch Zwei-Phototnenpolymerisation strukturiert wird. Das elektrooptische Bauelement ist dabei eine organische Leuchtdiode, die wenigstens eine organische Schicht zur Abgabe von Licht umfasst, wobei die Polymerschicht mit der eingebetteten Quantendot-Struktur an die wenigstens eine organische Schicht angrenzt. Die Quantendot-Struktur ist dazu ausgelegt, den Wellenlängenbereich, vorzugsweise einen blauen Wellenlängenbereich, von wenigstens einem Teil des Lichts, das von der wenigstens einen organischen Schicht abgegeben wird, zu verändern. Alternativ ist die Quantendot-Struktur dazu ausgelegt, eine Elektronen-Leitfähigkeit in einer Elektronen-Transportschicht und/oder eine Löcher-Leitfähigkeit in einer Löcher-Transportschicht des Bauelements zu verändern. Alternativ ist die Quantendot-Struktur zur direkten Lichtabgabe ausgelegt.

In einer Ausführungsform ist das Verfahren zum Herstellen optischer Antennen, vorzugsweise fraktaler Antennen, als das elektrooptische Bauelement ausgelegt.

Durch die derartige Strukturierung von Abschnitten der Polymerschicht, dass eine Quantendot-Struktur entsteht, ist es erstmals möglich, Quantendots auf kontrollierte und steuerbare Weise in bekannte Bauelemente einzubetten. Dadurch kann die Effizienz der elektrooptischen Bauelemente gesteigert werden oder kann die Wirkungsweise der elektrooptischen Bauelemente gezielt beeinflusst werden.

Die vorliegende Erfindung wird im Folgenden anhand der beigefügten Figuren beschrieben:
- Figur 1 zeigt ein elektrooptisches Bauelement mit einer Polymerschicht.
- Figur 2 zeigt eine elektrochemische Flüssigkeitszelle.
- Figur 3 zeigt eine erste organische Leuchtdiode der vorliegenden Erfindung.
- Figur 4 zeigt eine zweite organische Leuchtdiode der vorliegenden Erfindung.
- Figur 5 zeigt ein elektrooptisches Bauelement mit einer Graphenschicht.
- Figur 6 zeigt ein elektrooptisches Bauelement mit zwei Graphenschichten.

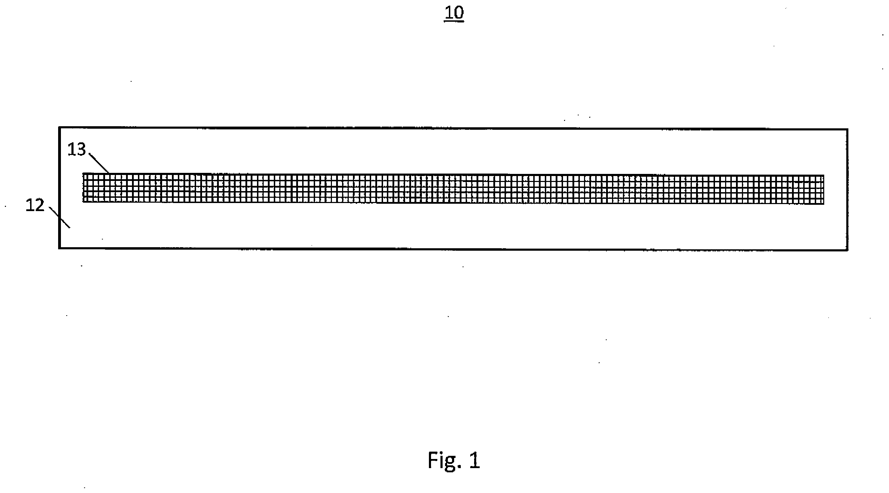

In den Figuren 1, 2, 5 und 6 sind Beispiele von elektrooptischen Bauelementen gezeigt, die nicht genau dem in den Ansprüchen angegebenen elektrooptischen Bauelement entsprechen. Die in den Figuren 1, 2, 5 und 6 gezeigten Beispiele dienen dem besseren Verständnis.

Figur 1 zeigt ein elektrooptisches Bauelement 10, in dem eine Polymerschicht 12 (bzw. ein Polymerblock) mit einer eingebetteten Quantendot-Struktur 13 aus einer Vielzahl von Quantendots versehen ist. Jeder Quantendot der Quantendot-Struktur 13 ist derart gestaltet und dimensioniert, dass sich für elektrische Ladungen (bspw. Elektronen oder Löcher) diskrete, d.h. quantisierte, Energieniveaus im Quantendot ausbilden. Die gesamte Quantendot-Struktur ist vorzugsweise derart gestaltet und dimensioniert, dass sich auch Quanteneffekte für die gesamte Quantendot-Struktur ergeben. Beispielweise kann sich eine Bandlücke in der Quantendot-Struktur 13 aufgrund der quantenmechanischen Kopplung einer Vielzahl von Quantendots ausbilden. Dazu müssen die einzelnen Quantendots eine Größenordnung von unter 25 nm aufweisen und sollten möglichst periodisch und möglichst dicht aneinander angeordnet sein. Jeder Quantendot wirkt wie einzeln ein künstliches Atom, die gesamte Quantendot-Struktur kann etwa die Eigenschaften eines Halbleiterkristalls nachbilden.

Die Eigenschaften der gesamten Polymerschicht 12 können dadurch gezielt durch die eingebrachte Quantendot-Struktur 13 beeinflusst werden. Da die Quantendot-Struktur 13 selber Quanteneffekte hervorruft (beispielsweise eine Bandlücke erzeugt), kann zum Beispiel ein zur Lichtabgabe (etwa über Ladungsrelaxation über die Bandlücke der Quantendot-Struktur 13) geeignetes elektrooptisches Bauelement 10 hergestellt werden. Ist bereits die Polymerschicht 12 zur Lichtabgabe geeignet (beispielweise aufgrund einer eigenen Bandlücke in der Polymerschicht), so kann die Quantendot-Struktur 13 (beispielweise durch Veränderung der Bandlücke des Polymers) die Wellenlänge des Lichts, das aus der Polymerschicht 12 abgegeben wird, beeinflussen. Beispielweise kann die Wellenlänge des Lichts verändert werden.

Die Polymerschicht 12 mit eingebetteter Quantendot-Struktur 13 kann durch ein Verfahren hergestellt werden, bei dem wenigstens ein Abschnitt der Polymerschicht 10 mittels Zwei-Photonenpolymerisation strukturiert wird. Die Quantendot-Struktur 13 kann durch Zwei-Photonenlithographie, welche den Effekt der Zwei-Photonenpolymerisation ausnutzt, so ausgelegt und dimensioniert werden, dass Quanteneffekte in der Struktur als Ganzes hervorgerufen werden. Die Quanteneffekte können dabei auch ohne die Einbettung von weiteren Quantendots hervorgerufen werden. Die kleinsten Elemente der Quantendot-Struktur 13 agieren dabei bereits alleine als Quantendots.

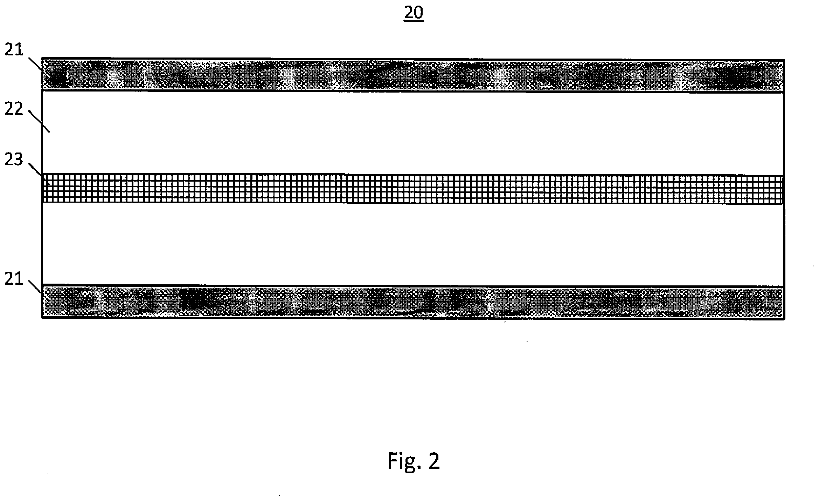

Figur 2 zeigt eine weitere Möglichkeit zur Nutzung der Quantendot-Struktur 23. Figur 2 zeigt insbesondere eine elektrochemische Flüssigkeitszelle 20 ("Liquid Electrochemical Cell", LEC). Die elektrochemische Flüssigkeitszelle 20 besteht aus einer Polymerschicht 22, auf deren beiden Oberflächen Elektroden 21 aufgebracht sind. Die Polymerschicht 22 ist vorzugsweise aus einem Emittermaterial (zur Lichtemission geeignetes Material) hergestellt, beispielsweise einem Material, das auch für organischen Leuchtdioden (OLEDs) verwendet wird. Geeignete Materialien sind beispielweise Polymere. Anstatt einer Polymerschicht könnte aber auch eine Schicht aus sogenannten ,Small Molecules' vorgesehen sein.

Die Polymerschicht 22 enthält auch einen Elektrolyten. Beim Anlegen einer Spannung an die Elektroden 21 formt sich durch die Wanderung des Elektrolyten zu den Elektroden 21 ein p-n-Übergang in der Polymerschicht 22. Die Polymerschicht 22 ist deshalb bei angelegter Spannung zur Lichtabgabe geeignet (der p-n-Übergang wird wie in einer herkömmlichen Leuchtdiode zur Lichtabgabe genutzt).

In die Polymerschicht 22 ist zusätzlich eine Quantendot-Struktur 23 eingebettet. Die Quantendot-Struktur 23 ist dreidimensional und mittels Zwei-Photonenpolymerisation in die Polymerschicht 22 eingeschrieben. Die Zwei-Photonenpolymerisation wird vorzugsweise mittels eines Femtosekunden-Lasers (z.B. Ti-Saphir-Laser) durchgeführt, der auf die Polymerschicht 22 fokussiert wird. Nur im Fokusbereich des Lasers, also stark lokalisiert, vollzieht sich eine chemische Reaktion, die zu einer Polymerisation der Polymerschicht 22 im Fokusbereich führt. Nicht polymerisierten Teile des Materials der Polymerschicht 22 können ausgewaschen werden. Dadurch kann eine dreidimensionale Struktur mit einer Auflösung bis zu 25 Nanometer entstehen. Mittels der Zwei-Photonenpolymerisation ist es möglich, den Ort und die Form der Quantendot-Struktur 23 innerhalb der Polymerschicht 22 des elektrooptischen Bauelements 20 genau festzulegen.

Vorzugsweise ist die Polymerschicht 22 zur Abgabe von Licht aus dem blauen Wellenlängenbereich ausgelegt. Eine Anwendungsmöglichkeit ist, die Quantendot-Struktur 23 so zu strukturieren (also die Dimensionen und Formen der einzelnen Quantendots sowie die Dimensionen und Form der gesamten Quantendot-Struktur 23 so zu wählen), dass die Quantendot-Struktur 23 den Wellenlängenbereich des Lichts, das von der Polymerschicht 22 abgegeben wird, verändern kann. Die Quantendot-Struktur 23 kann als eine zweite Anwendungsmöglichkeit auch selbst zur Lichtabgabe ausgelegt sein, um die Effizienz des insgesamt vom Bauteil 20 abgegebenen Lichts zu verbessern.

Bei der ersten Anwendungsmöglichkeit konvertiert die Quantendot-Struktur 22 wenigstens einen Teil des Lichts, das von der Polymerschicht 22 ausgesendet wird. Beispielsweise kann blaues Licht, das von der Polymerschicht 22 ausgesendet wird, teilweise in gelbes Licht konvertiert werden. Insgesamt kann dadurch ein weißleuchtendes elektrooptisches Bauelement 20 entstehen. Die Quantendot-Struktur 23 wirkt dabei ähnlich wie ein Leuchtstoff (z.B. Phosphor), wie er aus dem LED-Bereich bekannt ist.

Bei der zweiten Anwendungsmöglichkeit wird eine geeignete dreidimensionale Quantendot-Struktur 23 erzeugt und derart gestaltet, dass die einzelnen Quantendots so miteinander koppeln, dass eine zur Lichtabgabe geeignete Bandlücke in der gesamten Quantendot-Struktur 23 entsteht. Über diese Bandlücke kann die Quantendot-Struktur 23 selbst Licht abgeben, wenn eine Spannung an den Elektroden 21 anliegt. Dadurch kann die Effizienz des Bauelements 20 verbessert werden.

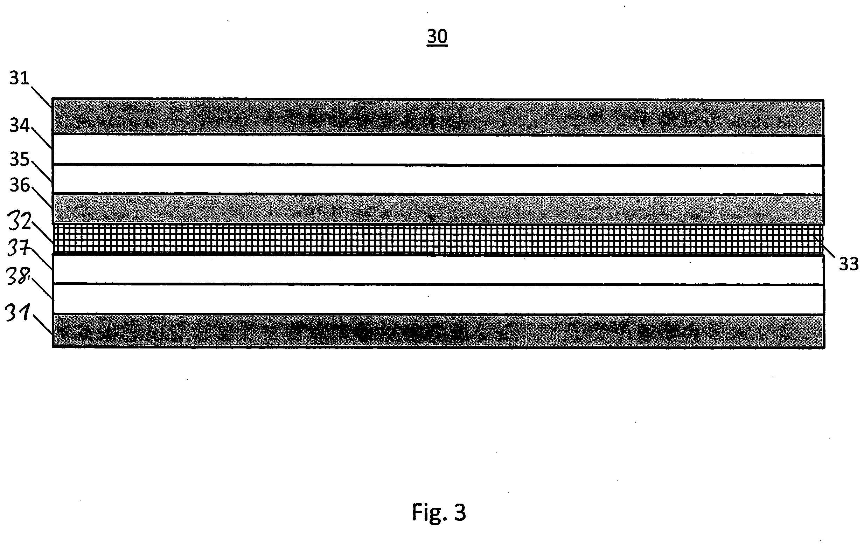

Figur 3 zeigt eine Ausführungsform eines elektrooptischen Bauelements 30 der vorliegenden Erfindung. Insbesondere ist das Bauelement 30 eine OLED. Die OLED besteht aus einer unteren Elektrode 31, auf die eine Löcher-Injektionsschicht 38 und eine Löcher-Transportschicht 37 aufgebracht sind. Die OLED 30 besteht weiter aus einer Polymerschicht 32, die auf der Löcher-Transportschicht 37 aufgebracht ist, in die eine Quantendot-Struktur 33 eingebettet ist. Eine als organische Schicht 36 ausgebildete Emissionsschicht ist zur Lichtabgabe geeignet. Die organische Schicht 36 ist vorzugsweise angrenzend auf die Quantendot-Struktur 33 aufgebracht. Auf die organische Schicht 36 wird ferner eine Elektronen-Transportschicht 35, eine Elektronen-Injektionsschicht 34 und schließlich eine weitere Elektrode 31 aufgebracht. In der Emissionsschicht der OLED 30 bildet sich ein p-n-Übergang und bei Anlegen einer Spannung an die Elektroden 31 kann die OLED 30 Licht aussenden. Vorzugsweise ist die OLED 30 der vorliegenden Erfindung eine OLED, die im blauen Wellenlängenbereich Licht abgibt. Allerdings können OLEDs beliebiger Farbe verwendet werden. Die OLED 30 mit eingeschriebener Quantendot-Struktur 33 kann verschiedene Verbesserungen zu herkömmlichen OLEDs aufweisen.

Zum Einen kann die Quantendot-Struktur 33 dazu ausgelegt sein, den Wellenlängenbereich und wenigstens einen Teil des von der organischen Schicht 36 abgegebenen Lichts zu verändern. Dabei ist das zu verändernde Licht vorzugsweise aus dem blauen Wellenlängenbereich. Die Quantendot-Struktur 33 wird dabei wiederum so dimensioniert und gestaltet, dass sie einen Teil des Lichts von der organischen Schicht 36 aufnimmt und in einer anderen Wellenlänge abstrahlt. Dadurch wird die Wellenlänge von wenigstens einem Teil des vorzugsweise blauen Lichts der organischen Schicht 36 konvertiert. Die Quantendot-Struktur 33 wirkt somit wie ein Leuchtstoff (Phosphor). Wiederum kann beispielsweise weißes Licht durch eine zusätzliche Emission von gelbem Licht aus der Quantendot-Struktur 33 zu blauem Licht aus der organischen Schicht 36 erzeugt werden.

Durch das Anordnen der Quantendot-Struktur 33 in der Nähe der beziehungsweise angrenzend an die organischen Emissionsschicht 36 kann aber auch die Effizienz der organischen Schicht 36 selbst erhöht werden, indem die Quantendot-Struktur 33 so gestaltet wird, dass sie über eigene Lichtemission die Effizienz der OLED 30 erhöht. Eine weitere Möglichkeit ist es, die Quantendot-Struktur 33 so zu dimensionieren und zu gestalten, dass die Leitfähigkeit für Löcher beziehungsweise für Elektronen in der Elektronen-Transportschicht beziehungsweise der Löcher-Transportschicht beeinflusst wird. Dies erhöht die Effizienz der OLED 30, da die Leitfähigkeitseigenschaften der beiden genannten Transportschichten maßgeblich die Effizienz der OLED 30 bestimmen.

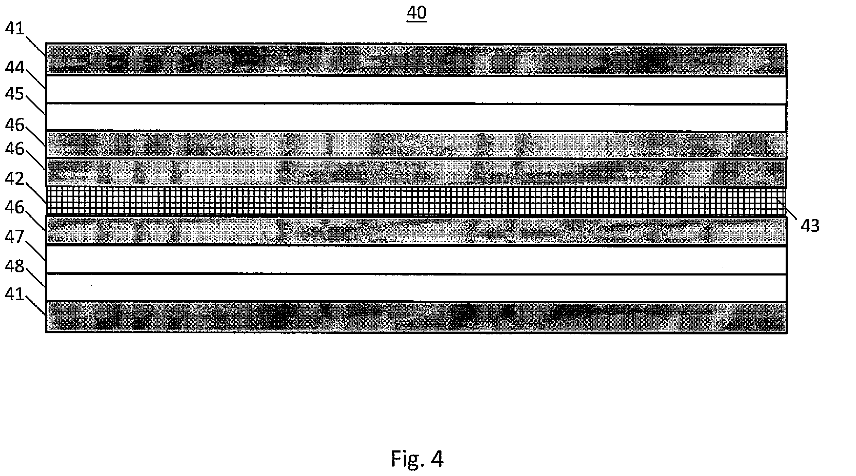

In Figur 4 ist eine besonders effiziente Ausführungsform einer OLED 40 gezeigt. Die OLED 40 unterscheidet sich von der OLED 30 aus Figur 3 dadurch, dass sie drei organische Schichten 46 statt einer aufweist. Die Quantendot-Struktur 43 ist zwischen zwei der drei organischen Schichten 46 eingebettet. Die Quantendot-Struktur 43 ist ferner so ausgelegt, dass sie gezielt die Leitfähigkeit zwischen den verschiedenen Schichten beeinflusst. Dies kann dadurch erreicht werden, dass die Quantendot-Struktur 43 einen Einfluss auf die Bandlücke der Emissionsschicht 36 nimmt. Diese Bandlücke kann dadurch beeinflusst werden, dass die Quantendot-Struktur 43 bei geeigneter Dimensionierung, typischerweise bei Strukturen mit Quantendots kleiner als 25nm, selbst eine Bandlücke ausbildet.

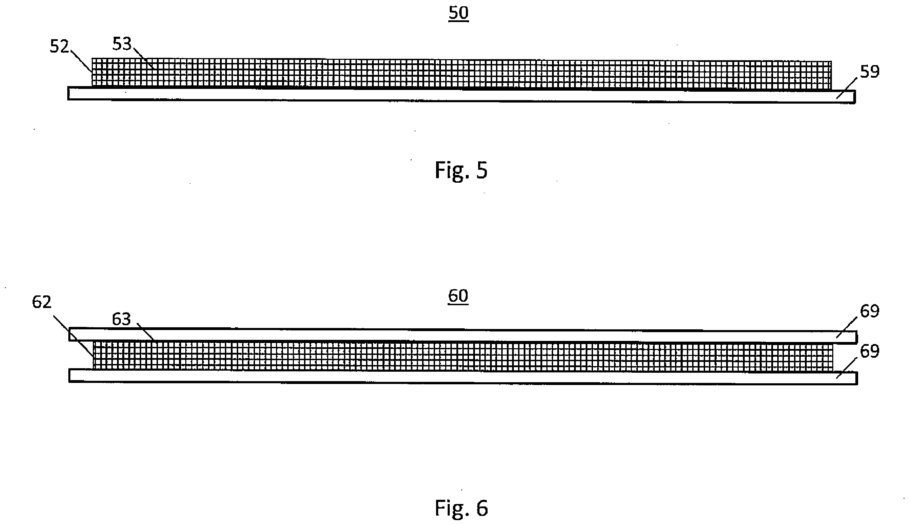

Die Figuren 5 und 6 betreffen eine weitere Möglichkeit, Quantendot-Strukturen 53 beziehungsweise 63 gezielt zur Beeinflussung eines elektrooptischen Bauelements 50, 60 zu nutzen. Das Bauelement 50 weist eine Graphenschicht 59 auf, auf der eine Polymerschicht 52 mit eingebetteter Quantendot-Struktur 53 aufgebracht ist. Graphen ist ein Material, welches aus hexagonalen Kohlenstoffstrukturen besteht und eine hohe Leitfähigkeit aufweist. Ein typisches Problem eines solchen Graphenmaterials besteht darin, dass die Leitfähigkeit beziehungsweise die Erzeugung und/oder Einstellung einer Bandlücke sehr schwierig und nur begrenzt möglich ist, da das Material von sich aus keine Bandlücke aufweist. Bei herkömmlichem Ansätzen wird dabei versucht, die Oberfläche von Graphen mit weiteren Strukturen zu versehen. Allerdings war bislang keine Möglichkeit gegeben, die gezielte Anordnung solcher Strukturen zu kontrollieren.

Durch die gezielte Anordnung der Quantendot-Struktur 53 auf dem Graphen an die Bandlücke des Graphen 59 bei entsprechender Dimensionierung der Quantendot-Struktur 53 in gewünschtem Maße verändert werden. Insbesondere kann, wie in Figur 6, eine Sandwichstruktur aus zwei benachbarten Graphenschichten 69 erzeugt werden, zwischen die eine Polymerschicht 62 mit eingebetteter Quantendot-Struktur 53 eingebracht ist. Die Einstellung der Bandlücke des Graphen kann nun sowohl durch die Quantendot-Struktur 53 als auch durch den Abstand zwischen den beiden Graphenschichten 69 eingestellt werden. Die Dimensionierung der Quantendot-Struktur 63 hat also doppelten Einfluss auf die Bandlücke des Graphenmaterials.

Die vorliegende Erfindung umfasst auch die Herstellung von Quantendot-Strukturen in Form sogenannter fraktaler Antennen. Entsprechende Bauelemente mit fraktalen Antennen-Strukturen sind daher auch von der Erfindung umfasst. Bei solchen Fraktal-Antennen handelt es sich um Strukturen in einem Größenbereich, der es ermöglicht, Licht gezielt zu empfangen beziehungsweise auszusenden (analog zu einer Antenne für Funksignale). Derartige Strukturen können Licht aus einem sehr großen Umgebungsbereich erfassen und gezielt in eine bestimmte Richtung bündeln und aussenden.

Insgesamt ermöglicht die Zwei-Photonenpolymerisation, beziehungsweise die Zwei-Photonenlithographie, welche den vorgenannten Effekt nutzt, Quantendot-Strukturen in bekannte elektrooptische Bauelemente wie z.B. Polymer-Bauelemente, LEDs, OLEDs, LECs oder Graphen-Bauelemente zu integrieren. Die Effizienz und Charakteristik der Bauelemente wird dabei verbessert beziehungsweise beeinflusst.

## Patentansprüche

1. Elektrooptisches Bauelement (30, 40), das umfasst
eine Polymerschicht (32, 42), in die eine Quantendot-Struktur (33, 43) eingebettet ist,
wobei das Bauelement (30, 40) eine organische Leuchtdiode ist, die wenigstens eine organische Schicht (36, 46) zur Abgabe von Licht umfasst,
**dadurch gekennzeichnet,**
**dass** die Quantendot-Struktur (33, 43) ein mittels Zwei-Photonenpolymerisation strukturierter Abschnitt der Polymerschicht (32, 42) ist, und
**dass** die Polymerschicht (32, 42) mit der eingebetteten Quantendot-Struktur (33, 43) an die wenigstens eine organische Schicht (36, 46) angrenzt, und
wobei
die Quantendot-Struktur (33, 43) dazu ausgelegt ist, den Wellenlängenbereich, vorzugsweise einen blauen Wellenlängenbereich, von wenigstens einem Teil des Lichts, das von der wenigstens einen organischen Schicht (36, 46) abgegeben wird, zu verändern, oder
die Quantendot-Struktur (33, 43) dazu ausgelegt ist, eine Elektronen-Leitfähigkeit in einer Elektronen-Transportschicht (35, 45) und/oder eine Löcher-Leitfähigkeit in einer Löcher-Transportschicht (37, 47) des Bauelements (30, 40) zu verändern, oder
die Quantendot-Struktur (33, 43) zur direkten Lichtabgabe ausgelegt ist.

2. Elektrooptisches Bauelement (40) gemäß Anspruch 1,
wobei, wenn die Quantendot-Struktur (33, 43) dazu ausgelegt ist, eine Elektronen-Leitfähigkeit in einer Elektronen-Transportschicht (35, 45) und/oder eine Löcher-Leitfähigkeit in einer Löcher-Transportschicht (37, 47) des Bauelements (30, 40) zu verändern, die Quantendot-Struktur (46) zwischen wenigstens zwei organischen Schichten (46) angeordnet ist; und
die Quantendot-Struktur (43) dazu ausgelegt ist, eine Bandlücke zwischen den Schichten des Bauelements (40) zu verändern

3. Verfahren zum Herstellen eines elektrooptischen Bauelements (30, 40) mit einer Quantendot-Struktur (33, 43) aus Quantendots in einer Polymerschicht (32, 42),
wobei das Bauelement (30, 40) eine organische Leuchtdiode ist, die wenigstens eine organische Schicht (36, 46) zur Abgabe von Licht umfasst,
**dadurch gekennzeichnet,**
**dass** die Quantendot-Struktur (33, 43) in wenigstens einem Abschnitt der Polymerschicht (32, 42) durch Zwei-Photonenpolymerisation strukturiert wird und dadurch Quantendots erzeugt werden, und
**dass** die Polymerschicht (32, 42) mit der eingebetteten Quantendot-Struktur (33, 43) an die wenigstens eine organische Schicht (36, 46) angrenzt, und
wobei
die Quantendot-Struktur (33, 43) dazu ausgelegt ist, den Wellenlängenbereich, vorzugsweise einen blauen Wellenlängenbereich, von wenigstens einem Teil des Lichts, das von der wenigstens einen organischen Schicht (36, 46) abgegeben wird, zu verändern, oder
die Quantendot-Struktur (33, 43) dazu ausgelegt ist, eine Elektronen-Leitfähigkeit in einer Elektronen-Transportschicht (35, 45) und/oder eine Löcher-Leitfähigkeit in einer Löcher-Transportschicht (37, 47) des Bauelements (30, 40) zu verändern, oder
die Quantendot-Struktur (33, 43) zur direkten Lichtabgabe ausgelegt ist.

4. Verfahren gemäß Anspruch 3 zum Herstellen optischer Antennen, vorzugsweise fraktaler Antennen, als das elektrooptische Bauelement.

## Claims

1. Electro-optical component (30, 40) comprising a polymer layer (32, 42), into which a quantum dot structure (33, 43) is embedded, wherein the component (30, 40) is an organic light-emitting diode which comprises at least one organic layer (36, 46) for emitting light, **characterized in that**
the quantum dot structure (33, 43) is a section of the polymer layer (32, 42) structured by means of two-photon polymerization, and
the polymer layer (32, 42) with the embedded quantum dot structure (33, 43) adjoins the at least one organic layer (36, 46), and wherein
the quantum dot structure (33, 43) is designed to change the wavelength range, preferably a blue wavelength range, of at least one part of the light emitted by the at least one organic layer (36, 46), or
the quantum dot structure (33, 43) is designed to change an electron conductivity in an electron transport layer (35, 45) and/or a hole conductivity in a hole transport layer (37, 47) of the component (30, 40), or
the quantum dot structure (33, 43) is designed for direct light emission.

2. Electro-optical component (40) according to claim 1,
wherein, if the quantum dot structure (33, 43) is designed to change an electron conductivity in an electron transport layer (35, 45) and/or a hole conductivity in a hole transport layer (37, 47) of the component (30, 40), the quantum dot structure (46) is arranged between at least two organic layers (46); and
the quantum dot structure (43) is designed to change a band gap between the layers of the component (40).

3. Method for producing an electro-optical component (30, 40) having a quantum dot structure (33, 43) composed of quantum dots in a polymer layer (32, 42), wherein the component (30, 40) is an organic light-emitting diode which comprises at least one organic layer (36, 46) for the emission of light, **characterized in that**
the quantum dot structure (33, 43) in at least one section of the polymer layer (32, 42) is structured by two-photon polymerization, thereby producing quantum dots, and
the polymer layer (32, 42) with the embedded quantum dot structure (33, 43) adjoins the at least one organic layer (36, 46), and
wherein
the quantum dot structure (33, 43) is designed to change the wavelength range, preferably a blue wavelength range, of at least one part of the light emitted by the at least one organic layer (36, 46), or
the quantum dot structure (33, 43) is designed to change an electron conductivity in an electron transport layer (35, 45) and/or a hole conductivity in a hole transport layer (37, 47) of the component (30, 40), or
the quantum dot structure (33, 43) is designed for direct light emission.

4. Method according to Claim 3 for producing optical antennas, preferably fractal antennas, as the electro-optical component.

## Revendications

1. Composant électro-optique (30, 40), comprenant une couche polymère (32, 42) dans laquelle est intégrée une structure de points quantiques (33, 43), ledit composant (30,40) consistant en une diode électroluminescente organique comprenant au moins une couche organique (36, 46) destinée à émettre de la lumière, **caractérisé en ce que**
la structure de points quantiques (33, 43) consiste en une section de la couche polymère (32, 42) qui est structurée par polymérisation biphotonique, et
**en ce que** la couche polymère (32, 42) comportant la structure de points quantiques (33, 43) intégrée jouxte l'au moins une couche organique (36, 46), et dans lequel composant
la structure de points quantiques (33, 43) est conçue pour modifier la plage de longueurs d'onde, de préférence une plage de longueurs d'onde bleue, d'au moins une partie de la lumière émise par l'au moins une couche organique (36, 46), ou
la structure de points quantiques (33, 43) est conçue pour modifier la conductivité des électrons dans une couche de transport d'électrons (35, 45) et/ou la conductivité des trous dans une couche de transport de trous (37, 47) du composant (30, 40), ou
la structure de points quantiques (33, 43) est conçue pour émettre directement de la lumière.

2. Composant électro-optique (40) selon la revendication 1,
dans lequel, lorsque la structure de points quantiques (33, 43) est conçue pour modifier la conductivité des électrons dans une couche de transport d'électrons (35, 45) et/ou la conductivité des trous dans une couche de transport de trous (37, 47) du composant (30, 40), la structure de points quantiques (46) est située entre au moins deux couches organiques (46) ; et
la structure de points quantiques (43) est conçue pour modifier une bande interdite entre les couches du composant (40).

3. Procédé de production d'un composant électro-optique (30, 40) comportant une structure (33, 43) de points quantiques dans une couche polymère (32, 42), ledit composant (30, 40) consistant en une diode électroluminescente organique comprenant au moins une couche organique (36, 46) destinée à émettre de la lumière, **caractérisé en ce que**
la structure de points quantiques (33, 43) consiste en au moins une section de la couche polymère (32, 42) qui est structurée par polymérisation biphotonique, entraînant la création de points quantiques, et
**en ce que** la couche polymère (32, 42) comportant la structure de points quantiques (33, 43) intégrée jouxte l'au moins une couche organique (36, 46), et
dans lequel
la structure de points quantiques (33, 43) est conçue pour modifier la plage de longueurs d'onde, de préférence une plage de longueurs d'onde bleue, d'au moins une partie de la lumière émise par l'au moins une couche organique (36, 46), ou
la structure de points quantiques (33, 43) est conçue pour modifier la conductivité des électrons dans une couche de transport d'électrons (35, 45) et/ou la conductivité des trous dans une couche de transport de trous (37, 47) du composant (30, 40), ou
la structure de points quantiques (33, 43) est conçue pour émettre directement de la lumière.

4. Procédé selon la revendication 3 de production d'antennes optiques, de préférence d'antennes fractales, à titre dudit composant électro-optique.
